# EUROPEAN PATENT APPLICATION

(11) **EP 4 386 858 A1**
(43) Date of publication of application: **19.06.2024**
(21) Application number: 22856157.7
(22) Date of filing: 09.08.2022
(51) Int. Cl.: H01L 29/778, H01L 29/66, H01L 29/24

(54) **MODULATION-DOPING-BASED HIGH MOBILITY ATOMIC LAYER SEMICONDUCTOR DEVICE AND MANUFACTURING METHOD THEREFOR**

(30) Priority: 10.08.2021 KR 20210105256
(71) Applicant: Korea University Research and Business Foundation, Seoul 02841 (KR)
(72) Inventor: LEE, Chul-Ho, Seoul 02780 (KR); LEE, Donghun, Seoul 08067 (KR)
(74) Representative: Schmitt-Nilson Schraud Waibel Wohlfrom Patentanwälte Partnerschaft mbB
(86) International application number: PCT/KR2022/011810
(87) International publication number: WO 2023/018160

(57) **Abstract**

Disclosed are a high-mobility atomic layer semiconductor device based on modulation doping and a method for fabricating the same, which prevent a charge scattering phenomenon caused by ionized impurities by modulation doping dopants such that the dopants are spatially separated from a channel layer of an atomic layer semiconductor device having an atomic layer semiconductor heterojunction structure band-aligned. According to an embodiment of the present disclosure, a high-mobility atomic layer semiconductor device based on modulation doping includes a substrate, an atomic layer semiconductor heterojunction structure band-aligned in type I or type II and including a channel layer allowing movement of an electron and a doping layer, wherein the channel layer and the doping layer are stacked on the substrate, and a dopant formed on the doping layer and including a material for supplying an electron or a hole to the channel layer. The dopant is doped while being spatially separated from the channel layer through the doping layer, instead of being directly doped into the channel layer.

## Description

### [TECHNICAL FIELD]

The present disclosure relates to a semiconductor device including an atomic layer for high mobility, which has a band-aligned heterojunction structure, and more particularly, relates to a semiconductor device including an atomic layer for high mobility based on modulation doping, capable of preventing charges from being scattered by ionized impurities, as dopants are spatially separated from a channel layer to be modulation-doped, and a method for fabricating the same.

The present disclosure is derived from research conducted as part of Nano Future Material Source Technology Development Program by the Ministry of Science and ICT (MSIT) (Project No.; 1711135342, Project No.; 2021M3H4A1A01079471, Research project name; development of monolithic integrated ultra-mobility atomic layer semiconductor device based on remote modulation doping, project management institution; National Research Foundation of Korea, task performing institution; Korea University, research period; May 10, 2021 to December 31, 2021). Meanwhile, there is no property interest of the Korean government in any aspect of the inventive concept.

### [BACKGROUND ART]

Unlike conventional Si or group III-V semiconductors, an atomic layer semiconductor material having a two-dimensional (2D) planar structure may maintain stable characteristic at a thickness of 1 nm due to the lack of unsaturated surface bonds, and is not severely degraded in characteristics even at a thinner thickness, so the atomic layer semiconductor material has been spotlighted as a material for a next-generation semiconductor device. In addition, heterojunction may be implemented on various substrates without crystallographic limitations, so the atomic layer semiconductor material is highly useful for a real device. However, since the atomic layer semiconductor material has a significant thin thickness, the atomic layer semiconductor material is significantly sensitive to the surface/interface characteristic, which degrades the characteristic of a device. In particular, when doping is performed to implement a high-performance device, electrons or holes may be scattered due to ionized impurities on the surface of the device or within the lattice of the device, which makes it difficult to implement a high-performance device.

### [DETAILED DESCRIPTION OF THE INVENTION]

### [TECHINICAL PROBLEM]

The present disclosure is provided to solve the problems caused in the related art, and is to provide a semiconductor device including an atomic layer for high mobility based on modulation doping and a method for fabricating the same, capable of preventing a charge scattering phenomenon caused by ionized impurities by modulation doping dopants such that the dopants are spatially separated from a channel layer of an atomic layer semiconductor device having an atomic layer semiconductor heterojunction structure band-aligned.

### [TECHNICAL SOLUTION]

According to an embodiment of the present disclosure, a semiconductor device including an atomic layer for high mobility based on modulation doping includes a substrate, an atomic layer semiconductor heterojunction structure band-aligned in type I or type II and including a channel layer allowing movement of an electron and a doping layer, in which the channel layer and the doping layer are stacked on the substrate, and a dopant formed on the doping layer and including a material for supplying an electron or a hole to the channel layer. The dopant is doped while being spatially separated from the channel layer through the doping layer, instead of being directly doped into the channel layer.

According to an embodiment of the present disclosure, in the semiconductor device including the atomic layer for high mobility based on the modulation doping, charge scattering caused by ionized impurities may be prevented as the dopant is doped.

The channel layer and the doping layer may form the atomic layer semiconductor heterojunction structure band-aligned.

The channel layer and the doping layer may include at least one type material selected from the group consisting of transition metal chalcogen compounds including MoS₂, MoSe₂, MoSe₂, WS₂, WSe₂, WSe₂, SnS₂, InSe₂, In₂Se₃, GaSe, HfSe₂, ZrS₂, and Bi₂O₂Se.

The dopant may include at least one type of material selected from the group consisting of Pph₃, BV, Polyetherimide (PEI), Tetrahydrofuran (THF), AuCl₃, F₄TCNQ, Mo(W)O₃, polyvinyl alcohol (PVA), Sb₂O₃·SnO₂(ATO), (3-Aminopropyl)triethoxysilane (APTES), NO₂, octadecyltrichlorosilane (OTS), XeF₂, Cs₂CO₃, Ca₂N, O₂, H₂O, NO₂, and 1H,1H,1H,2H,2H-Perfluorooctriethoxysilane (FOTS).

The atomic layer semiconductor heterojunction structure may further include an intermediate layer stacked between the channel layer and the doping layer.

The intermediate layer may include at least one material selected from the group consisting of h-BN, MoO₃, WO₃, TiO₃, V₂O₅, SiO₂, AlN, Al₂O₃, HfO₂, and ZrO₂ or a metal oxide of a material included in the channel layer.

According to an embodiment, the channel layer may include MoS₂, the intermediate layer may include h-BN, the doping layer may include WSe₂, and the dopant may include PPH₃.

According to an embodiment of the present disclosure, in the semiconductor device including the atomic layer for high mobility based on the modulation doping, electrons or holes in the doping layer implanted with the dopant spontaneously may move into the channel layer, such that the hole or the electron is trapped in a quantum well.

According to an embodiment of the present disclosure, a method for fabricating a semiconductor device including an atomic layer for high mobility based on modulation doping includes forming an atomic layer semiconductor heterojunction structure band-aligned in type I or type II by stacking a channel layer allowing movement of an electron and a doping layer, on a substrate, and forming a dopant, which includes a material for supplying an electron or hole to the channel layer, in the doping layer.

The forming of the dopant may include forming the dopant such that the dopant is doped into the channel layer while being spatially separated from the channel layer through the doping layer, instead of being directly doped into the channel layer.

The forming of the atomic layer semiconductor heterojunction structure may include forming the channel layer on the substrate, stacking an intermediate layer on the channel layer to prevent charge scattering, and forming the doping layer on the intermediate layer.

### [ADVANTAGEOUS EFFECTS OF THE INVENTION]

According to an embodiment of the present disclosure, there are provided a semiconductor device including an atomic layer for high mobility based on modulation doping and a method for fabricating the same, capable of preventing a charge scattering phenomenon caused by ionized impurities by modulation doping dopants such that the dopants are spatially separated from a channel layer of an atomic layer semiconductor device having an atomic layer semiconductor heterojunction structure band-aligned.

### [DESCRIPTION OF THE DRAWINGS]

FIG. 1 is a schematic view illustrating a semiconductor device including an atomic layer for high mobility based on modulation doping according to an embodiment of the present disclosure.
FIGS. 2 and 3 are views illustrating various heterojunction materials and band alignment structures constituting a semiconductor device including an atomic layer for high mobility based on modulation doping, according to various embodiments of the present disclosure.
FIG. 4 is an energy band diagram of a semiconductor device including an atomic layer for high mobility based on modulation doping according to an embodiment of the present disclosure.
FIG. 5 is a view illustrating a comparison between electrical characteristics of a semiconductor device including an atomic layer for high mobility based on modulation doping according to an embodiment of the present disclosure, and a device fabricated in an existing structure.
FIG. 6 is a graph illustrating electrical conductivity of a semiconductor device including an atomic layer for high mobility based on modulation doping according to an embodiment of the present disclosure.
FIG. 7 is a graph illustrating mobility-temperature characteristics of a device fabricated according to an embodiment of the present disclosure.
FIG. 8 is a transmission electron microscopy (TEM) image of a device fabricated according to an embodiment of the present disclosure.
FIG. 9 is a graph illustrating a photoluminescence (PL) spectrum of a device fabricated according to an embodiment of the present disclosure.
FIG. 10 is a graph illustrating electrical conductivity characteristics depending on the temperature of a device fabricated according to an embodiment of the present disclosure.

### [BEST MODE]

### [INDUSTRIAL APPLICABILITY]

Hereinafter, an embodiment of the present disclosure will be described in more detail with reference to the accompanying drawings. In the following description of the present disclosure, in the case where it is determined that the detailed description of a related known configuration or function may make the subject matter of the present disclosure unclear, the details thereof may be omitted. The embodiments of the present disclosure are provided to describe the present disclosure for those skilled in the art more completely, and may be modified in various forms in the following description, and the scope of the present disclosure should not be construed to be limited to the following description. Rather, these embodiments are provided as examples so that the present disclosure will be thorough and complete, and will fully convey the concept of the present disclosure to those skilled in the art.

In the drawings, embodiments of the present disclosure are not limited to the specific examples provided herein and are exaggerated for clarity. In the specification, the term "and/or includes any one or all possible combinations of at least one of relevant items listed-up. The terms used herein are provided to describe embodiments, not intended to limit the present disclosure. In the specification, a singular form may include plural forms unless otherwise specified.

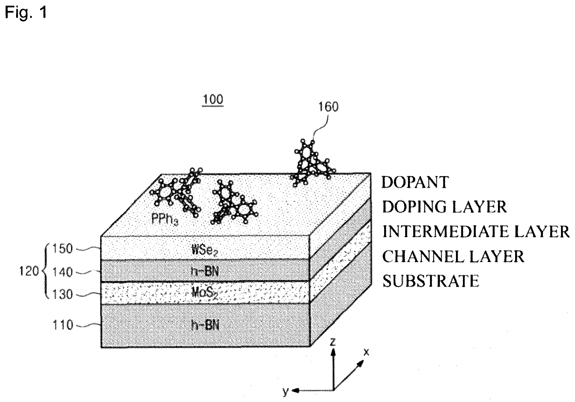

FIG. 1 is a schematic view illustrating a semiconductor device including an atomic layer for high mobility based on modulation doping, according to an embodiment of the present disclosure. Referring to FIG. 1, a semiconductor device 100 including an atomic layer for high mobility based on modulation doping according to an embodiment of the present disclosure is a two-dimensional semiconductor device having van der Waals heterostructures, and has a remote modulation-doping structure, such that dopants are spatially separated from a channel layer through which electrons move. Accordingly, electrons or holes may move freely without experiencing charge scattering by ionized impurities, such that the mobility of electrons/holes mobility may be improved.

According to an embodiment of the present disclosure, the semiconductor device 100 including the atomic layer for high mobility based on the modulation doping may include a substrate 110, an atomic layer semiconductor heterojunction structure 120, and a dopant 160. The atomic layer semiconductor heterojunction structure 120 may include a channel layer 130 stacked on the substrate 110 to allow the movement of an electron, an intermediate layer 140 stacked on the channel layer 130, and a doping layer 150 stacked on the intermediate layer 140.

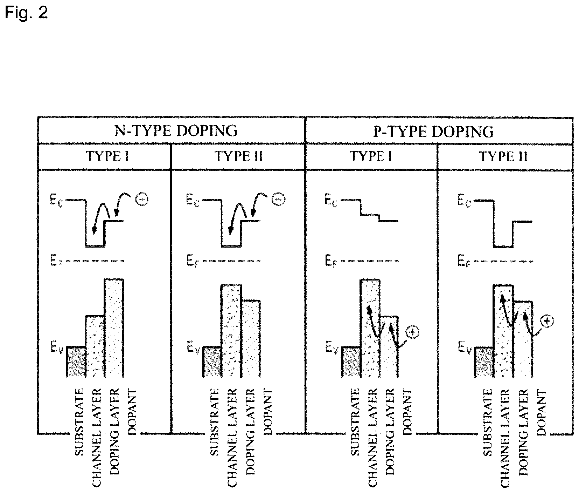

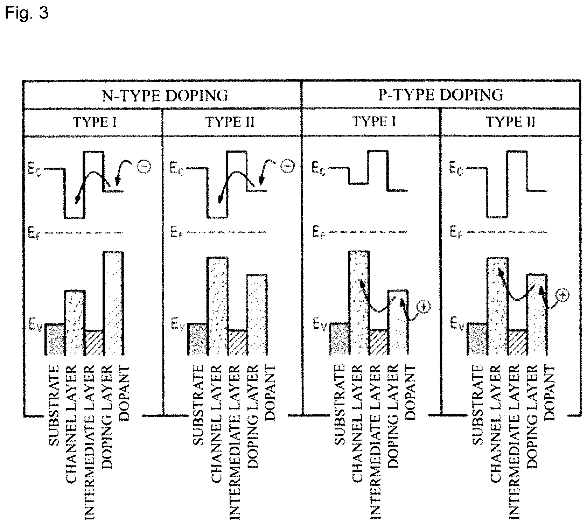

FIGS. 2 and 3 are views illustrating various heterojunction materials and band-aligned structures constituting a semiconductor device including an atomic layer for high mobility based on modulation doping, according to another embodiment of the present disclosure. FIG. 2 is a view illustrating a device having no intermediate layer between a channel layer and a doping layer, and FIG. 3 is a view illustrating a device having an intermediate layer formed between the channel layer and the doping layer. Referring to FIGS. 1 to 3, the channel layer 130, the intermediate layer 140, and the doping layer 150 may constitute an atomic layer semiconductor heterojunction structure having band alignment in Type I and Type II.

The dopant 160 may be formed in the doping layer 150 of the atomic layer semiconductor heterojunction structure 120. The dopant 160 may include a material for supplying electrons or holes to the channel layer 130. Electrons or holes in the doping layer 150 implanted with the dopant 160 spontaneously move to the channel layer 130 and are trapped in the quantum well.

According to an embodiment of the present disclosure, the dopant 160 is not directly doped into the channel layer 130, but is doped into the channel layer 130 through the doping layer 150 while being spatially separated from the channel layer 130. Accordingly, charges may be prevented from being scattered by ionized impurities.

According to an embodiment, a doping scheme of the dopant 160 may include a scheme in which the dopant 160 is positioned on the surface of the doping layer 150, a scheme in which a positive ion or a negative ion of a material constituting the doping layer 150 is substituted into another atom to form the dopant 160 inside the lattice of the doping layer 150, or a scheme of making the doping layer 150 defective to form the dopant 160 inside the lattice of the doping layer 150, and a scheme of changing (for example, phase-change) a partial region or the entire region of the doping layer 150 to form the dopant 160.

According to an embodiment of the present disclosure, the dopant 160 positioned on the doping layer 150 may include at least one type of material selected from the group consisting of Pph₃, BV, Polyetherimide (PEI), Tetrahydrofuran (THF), AuCl3, F4TCNQ, Mo(W)O₃, polyvinyl alcohol (PVA), Sb₂O₃·SnO₂(ATO), (3-Aminopropyl)triethoxysilane (APTES), NO₂, octadecyltrichlorosilane (OTS), XeF₂, Cs₂CO₃, Ca₂N, O₂, H₂O, NO₂, 1H, 1H, 1H, 2H, 2H-Perfluorooctriethoxysilane (FOTS).

When the dopant is formed by substituting a positive ion or a negative ion of a material constituting the doping layer 150 into another atom, the atom substituted from the positive ion or the negative ion of the doping layer 150 may include, for example, Nb, P, Re, W, N, Cl, S, Fe, Se, Mn, Er, Te, Zn, W, Mo, Cr or V.

When making the doping layer 150 defective or substituting the atom to form the dopant 160 within the lattice of the doping layer 150, electron beam irradiation, light irradiation, heat treatment, or plasma treatment may be used to make the lattice of the doping layer 150 defective or to substitute the atom.

The channel layer 130 may include at least one material selected from the group consisting of transition metal chalcogen compounds including MoS₂, MoSe₂, MoTe₂, WS₂, WSe₂, WTe₂, SnS₂, InSe, In₂Se₃, GaS, GaSe, HfS₂, HfSe₂, ZrS₂, ZrSe₂ and Bi₂O₂Se.

The intermediate layer 140 may include at least one material selected from the group consisting of h-BN, MoO₃, WO₃, TiO₃, V₂O₅, SiO₂, AlN, Al₂O₃, HfO₂, and ZrO₂. The intermediate layer 140 serves as a tunnel barrier layer for further suppressing a charge scattering phenomenon. The intermediate layer 140 may include a metal oxide of a material included in the channel layer 130.

The doping layer 150 may include at least one material selected from the group consisting of transition metal chalcogen compound including MoS₂, MoSe₂, WS₂, WSe₂, WTe₂, SnS₂, InSe, In₂Se₃, GaSe, HfS₂, HfSe₂, ZrS₂, ZrSe₂, and Bi₂O₂Se, and may include a transition metal chalcogen compound different from the material of the channel layer 130.

An experiment was performed to verify the performance by fabricating the semiconductor device 100 including an atomic layer for high mobility based on the modulation doping according to an embodiment of the present disclosure. After forming the channel layer 130 including MoS₂ on the substrate 110, the intermediate layer 140 and the doping layer 150 were vertically stacked on the result structure, and then the doping layer 150 was doped with a dopant 160. The intermediate layer 140 was formed of a hexagonal boron nitride (h-BN) material, and the doping layer 150 was formed of a WSe₂ material. As the dopant 160, triphenylphosphine (PPh₃) was used.

The h-BN material of the intermediate layer 140 was used to prevent the charge scattering phenomenon caused by the dopant 160 by spatially separating the carrier and the dopant. The WSe₂ material of the doping layer 150 was used to prevent direct doping to the channel layer 130 and to perform remote doping. The PCh₃ material corresponding to the dopant 160 was used to supply electrons to the semiconductor material due to the high relative energy level of the PCh₃ material.

The MoS₂ material was used due to the characteristic of being thin enough to be modulated by a back gate and having a low contact resistance even at low temperatures. In addition, the WSe2 material was used because the WSe2 material has a high bandgap, to make charge transfer doping easier than h-BN and has a lower electron affinity than the MoS2 material.

The Van der Waals h-BN spacer layer between WSe₂ and MoS₂ effectively confines doped carriers, and reduces remote optical phonon scattering from WSe2, and extrinsic scattering caused by alloy disorder and interface roughness typically present in bulk materials.

Hereinafter, the process of fabricating the device will be described in more detail. Two-dimensional material layers including MoS₂, WSe₂, graphene, and h-BN were formed on a SiO₂/p+-Si substrate having the thickness of 285 nm through a mechanical delaminating scheme. A wet transfer scheme was used to fabricate a van der Waals heterojunction structure including WSe₂/h-BN/MoS₂/h-BN and MoS₂/h-BN. First, when a lump of atomic layer material (channel layer or intermediate layer) was attached to a tape and then rubbed against a Si substrate, atomic layer semiconductor materials having various thicknesses adhere to the Si substrate. The substrate (h-BN/Si substrate) was spin-coated with polypropylene carbonate (PPC) at 1,000 rpm for one minute, and then heated in a hot plate at 60°C for one minute for dense bonding. After coating, a polydimethylsiloxane (PDMS) stamp was placed on the PPC/h-BN, and then the PPC around the PDMS was removed using a knife and immersed in deionized water.

After removing the PDMS/PPC/atomic layer material structure (PDMS/PPC/h-BN) from the Si substrate, the result structure is attached to a slide glass to form a slide glass/PDMS/PPC/atomic layer material structure. In this time, the slide glass is used to fix a transfer ratio, the PDMS is used to fix and support the atomic layer material, and the PPC is used as a kind of pool for removing the atomic layer material from the Si substrate. The slide glass/PDMS/PPC/atomic layer material fabricated in such a manner is in contact with a SiO2/Si substrate having Cr/Au (5/35 nm) electrodes pre-patterned to be attached to opposite end portions of the channel layer and then heated to the temperature of 100°C. In this time, as the PPC is melted, the slide glass/PDMS easily falls off the substrate. The PPC/atomic layer material/substrate structure remains on the desired substrate, and the PPC is melted for 30 minutes and removed using acetone. Thereafter, polymer by-products were removed from the surface of h-BN through treatment at 300°C for 10 minutes in an argon atmosphere.

The above-described transfer scheme is repeatedly performed on this structure (h-BN on SiO2/Si) to stack atomic layer materials (e.g., a MoS₂ sheet, and WSe2/h-BN) such that a doping layer/intermediate layer/channel layer/substrate structure is formed finally. As a control group, a channel layer/substrate structure is also formed. Meanwhile, for the preparation of a MoS₂ FET, patterned graphene was transferred onto a MoS₂ surface. To prepare a WSe₂/h-BN/MoS₂/h-BN heterojunction structure, a WSe₂/h-BN stack structure was additionally transferred onto a graphene-contact MoS₂/h-BN sample. Thereafter, the device was annealed at 300°C for 10 minutes under an argon atmosphere to remove polymer by-products and contaminants between the layers.

The two structures prepared in such a manner were doped, through spin coating (1000 rpm, 1 minute), with PCh₃ serving as a dopant for transfer charges, and heat treatment was performed at a temperature of 300°C for three minutes to remove the solvent. PCh₃ powders were dissolved in toluene to prepare PCh₃ solutions having various concentrations. To determine the chemical doping effect of PCh₃ on MoS₂, PCh₃ solutions having concentrations of 10, 30, and 45% were spin-coated on MoS₂ at 1,000 rpm for 1 minute, and then heated in a hot plate at a temperature of 300°C for 3 minutes to remove the solvent. To compare the temperature-dependent electrical properties of DD devices (MoS₂ FET) and MD devices (WSe₂/h-BN/MoS₂ FET), PCh₃ solutions having concentrations of 45% were doped twice.

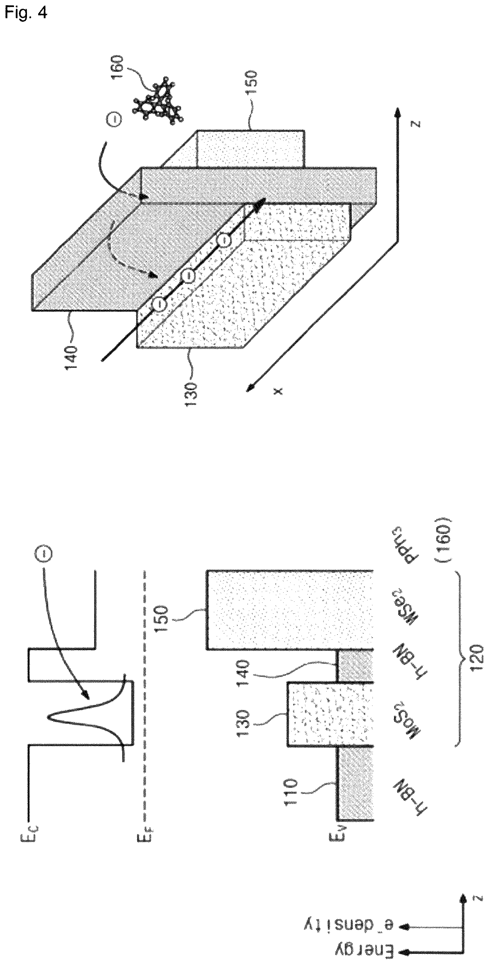

FIG. 4 is an energy band diagram of a semiconductor device including an atomic layer for high mobility based on modulation doping according to an embodiment of the present disclosure. Referring to FIGS. 1 and 4, electrons in the doping layer (e.g. WSe₂) 150 implanted with the PCh₃ serving as the dopant 160 spontaneously move into the channel layer (e.g. MoS₂) 130 having a lower conduction band end, such that the electrons are trapped in a quantum well.

To verify the doping possibility by transferring charges, electrical characteristics of a MoS₂ field-effect transistor (FET) device doped with n-type molecular dopant (PPh₃) were confirmed. A MoS₂ FET device was manufactured on an h-BN/SiO2/Si substrate to minimize external scattering from surface roughness, charge impurities, and polar optical phonons.

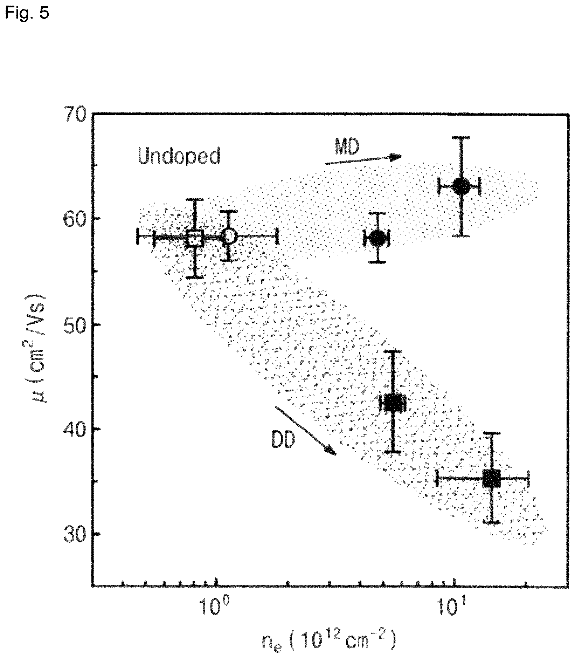

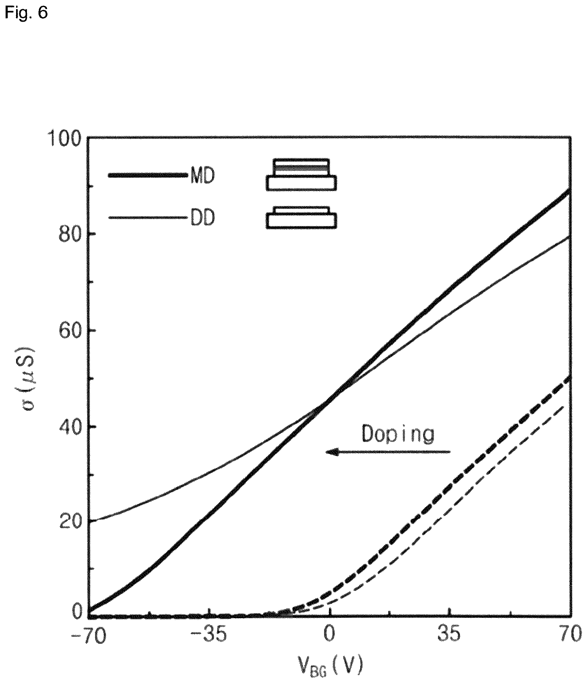

FIG. 5 is a view illustrating a comparison between electrical characteristics (a change in electron mobility depending on a dopant concentration) of a semiconductor device including an atomic layer for high mobility based on modulation doping according to an embodiment of the present disclosure and a device fabricated in an existing structure. FIG. 6 is a graph illustrating electrical conductivity of a semiconductor device including an atomic layer for high mobility based on the modulation doping according to an embodiment of the present disclosure. The electrical characteristics were analyzed by a semiconductor parameter analyzer (HP, 4145B) and a source meter (Keithly 2400). The device (directed doped device; DD device) in the existing structural was fabricated by forming a dopant in a channel layer (e.g. MoS₂) using a PPh3 solution having 45% concentration through the direct doping scheme.

As illustrated in FIG. 5, the DD device is expressed in a square, and the MD device is expressed in a circuit. An empty square and an empty circle represent the DD device and the MD device in an undoped state, respectively, two filled squares represent DD devices doped once and twice, and two filled circles represent MD devices doped once and twice. A line illustrated in a cross shape in the square and the circle is error bars representing standard deviations of measured values for five or more elements.

As illustrated in FIG. 6, a dotted line represents electrical conductivity before PPH₃ doping and a solid line represents electrical conductivity after the PPH₃ doping. Referring to FIGS. 1, 5, and 6, the threshold voltage of both the DD device (a DD structure having only the channel layer) and the modulation doping (MD) device (a doping layer (WSe₂)/intermediate layer (h-BN)/channel layer (MoS₂) heterojunction MD structure) corresponding to the comparative example is decreased according to the treatment of PPH₃ serving as an N-type dopant.

The DD device corresponding to the comparative example shows the mobility of charges (electrons) decreasing as the doping concentration of the dopant increases. However, the MM device fabricated according to the embodiment of the present disclosure shows the conductivity increasing after coating the dopant, and even if the concentration of the doping dopant increases, the mobility of charges does not decrease.

It may be estimated that this is because the dopant 160 and the channel layer 130 are spatially separated from each other in the MD device according to an embodiment of the present disclosure, such that the charge scattering phenomenon caused by the dopant 160 is prevented. The 2D sheet electron density (2D electron density) (ne) may be calculated by an equation I_{D}L/(qWV_{D}µ) (L: channel length, W: channel width, q: electron charge, and VD: drain voltage) according to the electric field mobility (µ) derived from the ID-VBG (drain current-backgate voltage) curve.

Depending on doping, the value of nₑ increases from 1.1 × 10¹² cm⁻² to 4.8 × 10¹² cm⁻² in the MD device (the present disclosure) and increases from 8.1 × 10¹¹ cm⁻² to 5.6 × 10¹² cm⁻² in the DD device (the comparative example). This means which PCh₃ molecules may modulate the carrier density of the MoS₂ channel layer without an excessive decrease in doping efficiency, through the remote charge transfer through WSe₂/h-BN layers, in the MD device as well as the DD device.

The electron density of both the DD device and the MD device may be adjusted depending on the PPh₃ concentration and the number of doping times. According to the experiment, the electron density of the DD device and the MD device was controlled up to 1.5×10¹³ cm⁻², 1.1×10¹³ cm⁻², respectively. In stacked heterojunction structures, electron transfer mainly occurs through MoS₂, and the contribution of WSe₂ is negligible. This is because pure WSe₂ essentially exhibits a p-type characteristic having high series resistance. Even after doping, WSe₂ exhibits much lower electron conductivity than MoS₂.

In addition to the modulation characteristics of the carrier density, the field mobility (µ) of the remote modulation doping under the condition that VBG (backgate voltage) = 0 is illustrated in FIG. 5. In the MD device, the field mobility (µ) is hardly changed even after doping, and is maintained at about 60 cm²V⁻¹s⁻¹. In contrast, in the DD device, the field mobility (µ) is reduced from 60 cm²V⁻¹s⁻¹ to 35 cm²V⁻¹s⁻¹ after doping.

These results imply which charge impurity scattering is prevented even at normal temperature (room temperature) in the heterojunction MD FET. Since charge scattering by ionized impurities is remarkable shown at a low temperature, mobility at the low temperature was additionally measured to experimentally verify the effect of preventing charge scattering suggested in the present disclosure.

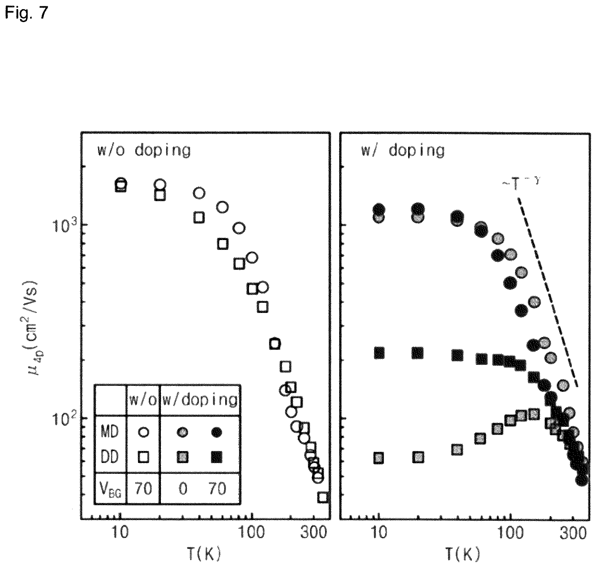

FIG. 7 is a graph illustrating mobility-temperature characteristics of a device fabricated according to an embodiment of the present disclosure. FIG. 7 is a curve illustrating 4-probe mobility (µ4p) before and after doping, as a function of temperature for the modulation doping device (MD) and a device (DD) not experiencing modulation doping, according to an embodiment of the present disclosure. The 4-probe mobility is measured by a lock-in amplifier (SR830, SR810, Stanford Research Systems).

Referring to FIGS. 1 and 7, when the dopant is not doped (w/o doping), even though the temperature decreases, the mobility of electrons does not decrease at a low temperature, in both the existing DD device and the MD device fabricated according to an embodiment of the present disclosure. However, in the DD device having the high concentration, which is implemented through the direct doping for the MoS₂ channel layer 130, the mobility of electrons increases when the temperature decreases from 300 K to 200 K, but decreases, as the temperature decreases, at a temperature below the range. This is because the mobility of charges is affected by a scattering phenomenon caused by a dopant on the surface or inside of the channel layer.

In contrast, it may be recognized that the structure (MD) employing the heterojunction structure and the modulation doping technology according to an embodiment of the present disclosure shows the mobility of electrons that continues to increase as the temperature decreases. These characteristics appear regardless of the change in the gate voltage. This may be because the charge scattering phenomenon caused by the dopant 160 is removed in the structure (MD) fabricated according to an embodiment of the present disclosure, even though the charge scattering phenomenon caused by the dopant 160 in the existing structure DD.

Under the condition that V_{BG} (backgate voltage) = 70 V, the MD device and the DD device before doping show the mobility having a similar temperature dependence, and show the mobility increased and converged below 100 K, as the temperature decreased from 300 K to 100 K. This implies which charge transfer is restricted by phonon scattering.

The MD device and the DD device after doping exhibit completely contrasting characteristics. In the high temperature range of 200 K to 300 K, the mobility (µ4p) of the MD device and the DD device show the mobility increasing as the temperature decreases, and follows a relationship of approximately µ=T^{-γ} (µ: mobility, T: absolute temperature, γ: phonon damping factor). In the high temperature, a phonon population follows Bose-Einstein, so the phonon scattering is dominant.

A phonon damping factor measured in the modulation doping (MD) device was 2.13, which is comparable to theoretical phonon damping factor predictions of 1.69 and 2.5 in monolayer MoS₂ and bulk MoS₂. In contrast, the DD device show a much lower phonon damping factor value (0.94) measured. This means which charge impurity scattering is apparently appeared due to the Coulomb potential of molecular dopants in close contact with a MoS₂ channel.

The most important feature of the temperature-dependent mobility appears in the low temperature region below 200 K where charge impurity scattering governs the charge transfer. The MD device SHOWS the mobility (µ4p) increasing monotonically as the temperature decreases continuously and begins to saturate below 100 K, which is similar to undoped devices.

In contrast, the DD device shows the mobility (µ4p) reaching a peak at the temperature of approximately 200 K, and gradually decreasing as the temperature further decreases to lower than 200 K. This characteristic is mainly observed under the condition that VBG (backgate voltage) = 0 V, where chemically doped electrons in the MoS2 channel contribute to the charge transfer predominantly. Under the condition where VBG = 70 V, the degree of reduction in mobility (µ4p) decreases. This is because a carrier screening effect increases by electrons additionally induced through electrostatic gating. The decrease in mobility resulting from temperature decreasing due to this negative phonon damping factor (γ) is caused only in the DD device regardless of the gate voltage. This means which impurities ionized from external dopants serve as a dominant scattering factor.

The mobility (µ₄ₚ) of the MD device is higher than that of the DD device, which is more remarkable at the low temperature. In particular, at the temperature of 10 K, the MD device has the mobility of 1100 cm²V⁻¹s⁻¹, which is much higher than that of the DD device, which is 63 cm²V⁻¹s⁻¹, when VBG = 0 V, and the MD device has the mobility of 1200 cm²V⁻¹s⁻¹, which is much higher than that of the DD device, which is 220 cm²V⁻¹s⁻¹ when VBG = 70 V. Such mobility characteristic appears because the spatially separation of electrons from the parent dopants of the electrons suppresses the scattering of impurities in the MD device.

Since a WSe₂ layer in the MD device may not be substituted with the h-BN layer, the WSe₂ layer is essential to suppress the scattering of charge impurities while achieving efficient charge transfer doping. When only h-BN having a thickness of 1 nm is used without the WSe₂ layer, Coulomb potential caused by the dopants may affect the distance of several nanometers. Accordingly, doping-induced scattering may not be effectively prevented. Meanwhile, since the tunneling probability decreases exponentially depending on the thickness of the tunnel barrier, the device fabricated with the h-BN layer having a thickness of 4 nm or more and the WSe₂/h-BN layer having an equal thickness of 4 nm or more may have lower doping efficiency, and the thickness of each layer is preferably fabricated to be less than 4 nm.

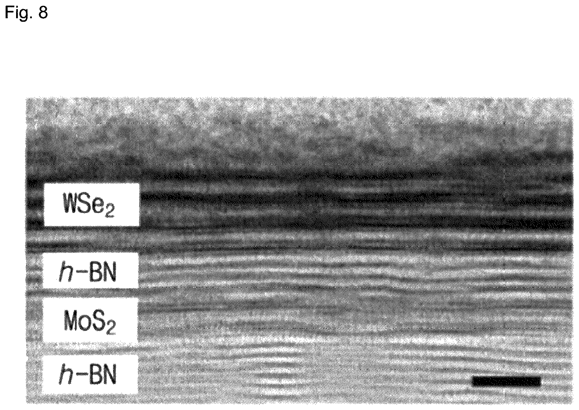

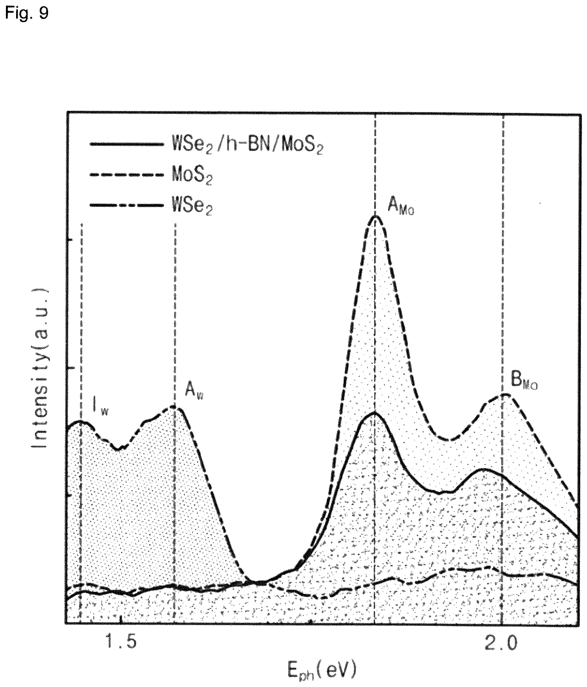

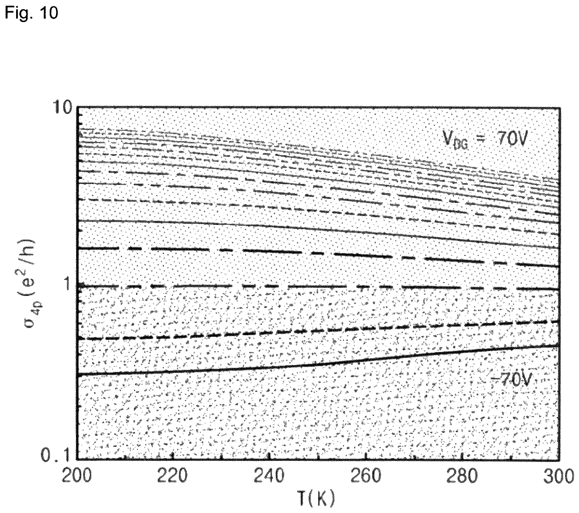

FIG. 8 is a transmission electron microscopy (TEM) image of the device fabricated according to an embodiment of the present disclosure. FIG. 9 is a graph illustrating a photoluminescence (PL) spectrum (Raman spectroscopy) of the device fabricated according to an embodiment of the present disclosure. FIG. 10 is a graph illustrating electrical conductivity characteristics depending on the temperature of the device fabricated according to an embodiment of the present disclosure. The PL spectrum is measured by an optical microscope including a 532 nm continuous wave laser 120 *µ*W and a monochromator (Andor, SOLIS 303i).

As illustrated in FIG. 8, the device fabricated according to an embodiment of the present disclosure includes four layers including WSe₂, three layers including h-BN, and three layers including MoS₂. As illustrated in FIG. 9, a solid line represents a PL spectrum of a WSe₂/h-BN/ MoS₂ region, a dotted line represents a PL spectrum of a MoS₂ region, and a double point chain line represents a PL spectrum of the WSe₂ region. As illustrated in FIG. 9, Iw, Aw, A_{Mo}, and B_{Mo} respectively represent an indirect transition of WSe₂, "A" exciton of WSe₂, "A" exciton of MoS₂, and "B" exciton of MoS2.

Peaks were observed at 1.83 eV for "A" excitons (AMo) of MoS₂ in three layers, 2.00 eV for "B" excitons (BMo), 1.45 eV for indirect transition (IW) of WSe₂ in four layers, 1.57 eV for "A" excitons (AW). In the WSe₂/h-BN/ MoS₂ junction region, the intensity of all the peaks is reduced as a result of the interlayer charge transfer process of photogenerated excitons.

PL mapping, in which "A" exciton (AMo) of MoS₂ corresponds to 1.83 eV (AMo), indicates a homogeneous reduction of intensity in the overlapping region. This means that the charge transfer interaction occurs uniformly in the overlapping region, due to the high bonding properties of the stacked WSe₂/h-BN/ MoS₂ heterojunction structure. The insertion of h-BN maintains the charge transfer illustrated in the WSe₂/MoS₂ heterojunction and the corresponding PL quenching behavior. This is because the h-BN of the three layers between WSe₂ and MoS₂ is thin enough for tunneling of charge carriers.

FIG. 10 illustrates temperature dependence of electron transfer characteristics (4-probe conductivity (σ4p)) in a remote modulation doping device (MoS₂ MD FET). To evaluate the charge transfer characteristics by reducing the effect of contact resistance, electrical characteristics were evaluated for graphene-contact devices using four-probe measurements.

It may be recognized from FIG. 10 that 4-probe conductivity (σ4p) increases as the temperature decreases when VBG (backgate voltage) exceeds -50 V, and 4-probe conductivity (σ4p) decreases as the temperature decreases when VBG (backgate voltage) is less than -50 V. This means that phonon scattering is prevented as the temperature decreases, but other scattering, such as impurity scattering, is not substantially involved as the temperature decreases, in the remote modulation doping device. Graphene contact device exhibited a contact resistance than that of a gold (Au) contact device, such that the excellent ohmic contact characteristics are exhibited.

A Schottky barrier height was further analyzed from Arrhenius plots for evaluation of contact performance. As the gate voltage increases, an unpinned Fermi level of graphene is effectively aligned with the conduction band of MoS₂, so the Schottky barrier height of the modulation doping device extracted from the slope of the Arrhenius plot approximates 0 eV.

Metal-insulator transition (MIT) characteristics of various gate voltages illustrated in FIG. 10 were verified from a 4-probe conductivity (σ4p) curve as a function of temperature. As described above, the modulation doping device has a characteristic of a metal phase in which a 4-probe conductivity (σ4p) increases as a temperature decreases when a back gate voltage (VBG) exceeds -50 V, and, an insulating property in which a 4-probe conductivity (σ4p) decreases as a temperature decreases, when a VBG (back gate voltage) is lower than -50 V. The modulation doping devices have been illustrated that a metal-insulator transition (MIT) has a 2D electron gas (2DEG) characteristic which is made around a conductivity value of e2/h (h: Planck constant, e: electron charge).

Referring to FIGS. 8 to 10, it may be recognized that electric charges are easily moved between the channel layer and the doping layer due to conduction band offset, such that electrons introduced into WSe₂ of an upper layer used as the doping layer are spontaneously well transferred to MoS₂ used as a channel layer, thereby improving electrical conductivity characteristics. Furthermore, it may be recognized that the structure fabricated according to the present disclosure has a small contact resistance, and electrons are well bound to the two-dimensional structure.

According to an embodiment of the present disclosure, the semiconductor device including the atomic layer for high mobility based on the modulation doping has an atomic layer thin film structure including two-dimensional materials, thereby contributing to the miniaturization of the device and improving the performance of the device by preventing charge scattering. It may be used to fabricate various low-power and high-performance devices, such as high-mobility 2D transistors (HEMTs), logic devices, and non-memory semiconductor devices, and may be applied to various fields, such as microprocessors and logic circuits, with high demand for high-performance semiconductors.

In particular, the semiconductor device including the atomic layer for high mobility based on the modulation doping according to an embodiment of the present disclosure may be applied not only to mobile devices but also to various fields, such as big data analysis, artificial intelligence, IoT, nanotechnology, or autonomous vehicles, due to technical advantages such as ultra-small, high mobility, high flexibility, and low power consumption. Furthermore, it may be applied to next-generation mobile electronic devices, wearable devices, and displays requiring high-density, and low-performance devices.

Although embodiments of the present disclosure have been described above, the present disclosure is provided only for the illustrative purpose, and the present disclosure is not limited thereto, and should be interpreted as having a broadest range according to the basic idea disclosed in this specification. Those skilled in the art may combine and substitute the disclosed embodiments to implement a pattern with a shape which is not indicated, but the combination and the substitution fall within the scope of the present disclosure. In addition, those skilled in the art may easily change or modify the embodiments disclosed according to this specification, and it is clear that such change or modification also falls within the scope of the present disclosure.

## Claims

1. A semiconductor device including an atomic layer for high mobility based on modulation doping, the semiconductor device comprising:
a substrate;
an atomic layer semiconductor heterojunction structure band-aligned in type I or type II and including a channel layer allowing movement of an electron and a doping layer, wherein the channel layer and the doping layer are stacked on the substrate; and
a dopant formed on the doping layer and including a material for supplying an electron or a hole to the channel layer,
wherein the dopant is doped while being spatially separated from the channel layer through the doping layer, instead of being directly doped into the channel layer.

2. The semiconductor device of claim 1, wherein charge scattering caused by ionized impurities is prevented as the dopant is doped.

3. The semiconductor device of claim 1, wherein the channel layer and the doping layer are selected from among transition metal chalcogen compounds having the atomic layer semiconductor heterojunction structure band-aligned.

4. The semiconductor device of claim 3, wherein the channel layer and the doping layer includes at least one type material selected from the group consisting of transition metal chalcogen compounds including MoS₂, MoSe₂, MoSe₂, WS₂, WSe₂, WSe₂, SnS₂, InSe₂, In₂Se₃, GaSe, HfSe₂, ZrS₂, and Bi₂O₂Se.

5. The semiconductor device of claim 1, wherein the dopant includes at least one type of material selected from the group consisting of Pph₃, BV, Polyetherimide (PEI), Tetrahydrofuran (THF), AuCl₃, F₄TCNQ, Mo(W)O₃, polyvinyl alcohol (PVA), Sb₂O₃·SnO₂(ATO), (3-Aminopropyl)triethoxysilane (APTES), NO₂, octadecyltrichlorosilane (OTS), XeF₂, Cs₂CO₃, Ca₂N, O₂, H₂O, NO₂, and 1H,1H,1H,2H,2H-Perfluorooctriethoxysilane (FOTS).

6. The semiconductor device of claim 1, wherein the atomic layer semiconductor heterojunction structure further includes:
an intermediate layer stacked between the channel layer and the doping layer.

7. The semiconductor device of claim 6, wherein the intermediate layer includes:
at least one material selected from the group consisting of h-BN, MoO₃, WO₃, TiO₃, V₂O₅, SiO₂, AlN, Al₂O₃, HfO₂, and ZrO₂ or a metal oxide of a material included in the channel layer.

8. The semiconductor device of claim 6, wherein the channel layer includes MoS₂, the intermediate layer includes h-BN, the doping layer includes WSe₂, and the dopant includes PPH₃.

9. The semiconductor device of claim 1, wherein electrons or holes in the doping layer implanted with the dopant spontaneously move into the channel layer, such that the hole or the electron is trapped in a quantum well.

10. A method for fabricating a semiconductor device including an atomic layer for high mobility based on modulation doping, the method comprising:
forming an atomic layer semiconductor heterojunction structure band-aligned in type I or type II by stacking a channel layer allowing movement of an electron and a doping layer, on a substrate; and
forming a dopant, which includes a material for supplying an electron or hole to the channel layer, in the doping layer,
wherein the forming of the dopant includes:
forming the dopant such that the dopant is doped into the channel layer while being spatially separated from the channel layer through the doping layer, instead of being directly doped into the channel layer.

11. The method of claim 10, wherein charge scattering caused by ionized impurities is prevented as the dopant is doped.

12. The method of claim 10, wherein the channel layer and the doping layer are selected from among transition metal chalcogen compounds having the atomic layer semiconductor heterojunction structure band-aligned.

13. The method of claim 12, wherein the channel layer and the doping layer includes at least one type material selected from the group consisting of MoS₂, MoSe₂, MoSe₂, WS₂, WSe₂, WSe₂, SnS₂, InSe₂, In₂Se₃, GaSe, HfSe₂, ZrS₂, and Bi₂O₂Se.

14. The method of claim 10, wherein the forming of the dopant includes:
positioning the dopant on a surface of the doping layer, substituting a positive ion or a negative ion of a material constituting the doping layer into another atom to form the dopant inside a lattice of the doping layer, making the doping layer defective to form the dopant inside a lattice of the doping layer, or changing a partial region or an entire region of the doping layer to form the dopant.

15. The method of claim 14, wherein the dopant positioned in the doping layer includes:
at least one type of material selected from the group consisting of Pph₃, BV, Polyetherimide (PEI), Tetrahydrofuran (THF), AuCl₃, F₄TCNQ, Mo(W)O₃, polyvinyl alcohol (PVA), Sb₂O₃·SnO₂(ATO), (3-Aminopropyl)triethoxysilane (APTES), NO₂, octadecyltrichlorosilane (OTS), XeF₂, Cs₂CO₃, Ca₂N, O₂, H₂O, NO₂, and 1H,1H,1H,2H,2H-Perfluorooctriethoxysilane (FOTS).

16. The method of claim 10, wherein the forming of the atomic layer semiconductor heterojunction structure includes:
forming the channel layer on the substrate;
stacking an intermediate layer on the channel layer to prevent charge scattering; and
forming the doping layer on the intermediate layer.

17. The method of claim 16, wherein the intermediate layer includes:
at least one material selected from the group consisting of h-BN, MoO₃, WO₃, TiO₃, V₂O₅, SiO₂, AlN, Al₂O₃, HfO₂, and ZrO₂ or a metal oxide of a material included in the channel layer.

18. The method of claim 16, wherein the channel layer includes MoS₂, the intermediate layer includes h-BN, the doping layer includes WSe₂, and the dopant includes PPH₃.
